(19) Europäisches Patentamt
European Patent Office
Office européen des brevets

(11) **EP 2 963 678 A1**

(12) **EUROPEAN PATENT APPLICATION**
published in accordance with Art. 153(4) EPC

(43) Date of publication:
**06.01.2016 Bulletin 2016/01**

(21) Application number: **14863060.1**

(22) Date of filing: **26.12.2014**

(51) Int Cl.:
**H01L 21/337** (2006.01)    **H01L 21/338** (2006.01)
**H01L 29/808** (2006.01)    **H01L 29/812** (2006.01)

(86) International application number:
**PCT/JP2014/084600**

(87) International publication number:
**WO 2015/145913 (01.10.2015 Gazette 2015/39)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **26.03.2014 PCT/JP2014/058677**

(71) Applicants:
• **NGK Insulators, Ltd.**
**Nagoya-shi, Aichi 467-8530 (JP)**
• **University of Yamanashi**
**Kofu-shi, Yamanashi 400-8510 (JP)**

(72) Inventors:
• **SHIMIZU Naohiro**
**Nagoya-shi**
**Aichi 467-8530 (JP)**
• **YANO Koji**
**Kofu-shi**
**Yamanashi 400-8510 (JP)**

(74) Representative: **Naylor, Matthew John et al**
**Mewburn Ellis LLP**
**City Tower**
**40 Basinghall Street**
**London EC2V 5DE (GB)**

(54) **SEMICONDUCTOR DEVICE**

(57)    The present invention relates to a semiconductor device. The semiconductor device includes an n-type semiconductor region (12), an n-type source region (14), an n-type drain region (16), and a plurality of p-type embedded gate regions (18). Further, this semiconductor device has super junction structure (38). The super junction structure (38) is formed by a plurality of p-type first regions (36p) extending from the respective embedded gate regions (18) toward the drain region (16), respectively, and an n-type second region (36n) positioned between the first regions (36p). Further, the embedded gate regions (18) are connected to upper portions of the first regions (36p).

FIG. 1

# Description

Technical Field

The present invention relates to a semiconductor device such as a static induction transistor, static induction thyristor, etc.

Background Art

As a semiconductor device having super junction structure, vertical power MOSFET having super junction structure in its drift layer has been known. When the semiconductor device having super junction structure in its drift layer is in the OFF state, a depletion layer is expanded from each of a plurality of parallel p-n junctions between the p-type column and the n-type column toward both sides of the p-type column and the n-type column to deplete the drift layer at a low electric field intensity. This structure achieves the high withstand voltage. Further, in the MOSFET having super junction structure, the ON resistance having the trade-off relationship with the withstand voltage is decreased advantageously (see Japanese Laid-Open Patent Publication No. 2012-004173). In a silicon carbide static induction type transistor, though there has already been an attempt to apply super junction to improve the performance (see Japanese Patent No. 3284120), since the surface structure is complicated, downsizing of super junction is difficult.

Further, in a conventional technique, a semiconductor device for electric power having a super junction electrostatic induction type transistor capable of improving characteristics of inverse mode operation of a transistor is known (Japanese Laid-Open Patent Publication No. 2010-045218). In this semiconductor device, a p-type gate drift layer is expanded in a longitudinal direction to form a columnar shape, and super junction structure is formed by the p-type gate drift layer and an n-type drift layer. However, in this semiconductor device, since the p-type gate drift layer also serves as a gate region, the ON resistance may become high, and the withstand voltage in the OFF state may become low undesirably.

Summary of the Invention

An object of the present invention is to provide a semiconductor device which utilizes advantages of super junction structure for making it possible to achieve the desired ON state characteristics and OFF state characteristics. It should be noted that the ON state characteristics represent conductive characteristics, and the OFF state characteristics represent withstand voltage characteristics.

[1] A semiconductor device according to the present invention includes a semiconductor region having a first conductivity type, a source region having the first conductivity type formed on one surface of the semiconductor region, a drain region having the first conductivity type formed on another surface of the semiconductor region, and a plurality of embedded gate regions having a second conductivity type which are located closer to the source region than to the drain region in the semiconductor region. Super junction structure is formed by a plurality of first regions having the second conductivity type extending respectively from the embedded gate regions toward the drain region and a second region having the first conductivity type provided between the first regions. The first regions are p-type, the second region is n-type, and the embedded gate regions are p-type. The embedded gate regions are connected to upper portions of the first regions.

[2] In the present invention, a width of the embedded gate regions may be larger than a width of the first regions, both sides of the embedded gate regions may protrude in a transverse direction beyond the first regions, a length of the channel region provided between the adjacent embedded gate regions may be equal to or less than a thickness of the embedded gate regions, an impurity concentration of the source region may be $10^{17}$ cm$^{-3}$ or more and less than $10^{21}$ cm$^{-3}$, an impurity concentration of the embedded gate regions may be $10^{18}$ cm$^{-3}$ or more and less than $10^{21}$ cm$^{-3}$, and an impurity concentration of the first regions may be $10^{15}$ cm$^{-3}$ or more and less than $10^{18}$ cm$^{-3}$.

[3] In particular, the upper ends of the embedded gate regions may contact a lower end of the source region.

[4] Further, preferably, the semiconductor device further includes an n-type region having low impurity concentration of $10^{16}$ cm$^{-3}$ or less, or an intrinsic semiconductor region, or an active high resistance semiconductor layer that may be located over a depth which is larger than 1/2 and equal to or less than 5/6 of the thickness tg of the embedded gate regions, from the upper ends of the embedded gate regions (see Japanese Patent No. 4832723).

[5] In the present invention, the embedded gate regions may extend in one direction, and may be arrayed in another direction perpendicular to the one direction.

[6] In this case, portions of the semiconductor region between the embedded gate regions may form channel regions, and the channel regions may extend in the one direction, and may be arrayed in the other direction.

[7] Further, the source region may extend over the channel regions.

[8] Alternatively, at least the source region and a junction surface of the super junction structure may extend in parallel to each other.

[9] Alternatively, at least the source region and a junction surface of the super junction structure may extend in perpendicular to each other.

[10] Alternatively, the source region may be separated into separate portions, and on the channel regions, the separate portions of the source region may extend in the one direction, and may be arrayed in the other direction.

[11] In this case, further, the source region may be separated into island portions, and the island portions of the source region may be arrayed in the one direction and the other direction.

[12] In [6] to [11], a ratio of a length of the channel region to a thickness of the semiconductor region may be equal to or less than 8/100.

[13] In this case, preferably, the length of the channel region to the thickness of the semiconductor region may be 1/300 or more and 6/100 or less.

[14] In the present invention, a width of the first region may be substantially the same as a width of the second region.

[15] In the present invention, preferably, a total impurity amount of the first regions is substantially same as a total impurity amount of the second regions.

As described above, in the semiconductor device according to the present invention, it is possible to improve the ON state characteristics and the OFF state characteristics utilizing the advantages of super junction structure.

Brief Description of the Drawings

FIG. 1 is a cross sectional view showing main components of a semiconductor device (first semiconductor device) according to a first embodiment of the present invention;

FIG. 2A is a cross sectional view taken along a line IIA-IIA in FIG. 1, and FIG. 2B is a cross sectional view taken along a line IIB-IIB in FIG. 2A;

FIG. 3 is a graph showing ON state characteristics of a the first semiconductor device;

FIG. 4 is a graph showing OFF state characteristics of the first semiconductor device;

FIG. 5 is a graph showing changes in breakdown voltages relative to variations of impurity concentration of a first region and impurity concentration of a second region of super junction structure;

FIG. 6 is a cross sectional view showing main components of a semiconductor device (second semiconductor device) according to a second embodiment of the present invention;

FIG. 7A is a cross sectional view taken along a line VIIA-VIIA in FIG. 6, and FIG. 7B is a cross sectional view taken along a line VIIB-VIIB in FIG. 7A;

FIG. 8 is a cross sectional view showing main components of a semiconductor device (third semiconductor device) according to a third embodiment of the present invention;

FIG. 9A is a cross sectional view taken along a line IXA-IXA in FIG. 8, and FIG. 9B is a cross sectional view taken along a line IXB-IXB in FIG. 9A;

FIG. 10 is a cross sectional view showing main components of a semiconductor device (fourth semiconductor device) according to a fourth embodiment of the present invention;

FIG. 11 is a graph showing the characteristics of the conduction current density $J_D$ relative to the change in the drain-source voltage $V_{DS}$ in the first semiconductor device, the second semiconductor device, and the third semiconductor device;

FIG. 12 is a graph showing the characteristics of the gate current density $J_G$ relative to the change in the drain-source voltage $V_{DS}$ in the first semiconductor device, the second semiconductor device, and the third semiconductor device;

FIG. 13A is a cross sectional view showing main components of a semiconductor device (fifth semiconductor device) according to a fifth embodiment of the present invention, and FIG. 13B is a cross sectional view showing main components taken from portions of gate extraction regions of the fifth semiconductor device as in the case of FIG. 2B;

FIG. 14 is a cross sectional view showing main components of a semiconductor device having conventional structure;

FIG. 15A is a graph showing the potential in the ON state and the potential in the OFF state in the fifth semiconductor device, and FIG. 15B is a graph showing the potential in the ON state and the potential in the OFF state in the semiconductor device having conventional structure, where the "POTENTIAL" in the figures represents potential energy;

FIG. 16A is a characteristic graph showing the changes in the drain-source voltage and output current over time at the time of turning on the fifth semiconductor device, and FIG. 16B is a characteristic graph showing the changes in the drain-source voltage and the output current over time at the time of turning on the semiconductor device having the conventional structure; and

FIG. 17A is a cross sectional view schematically showing an area around a channel region and a gate region of an FET (field effect transistor), and FIG. 17B is a graph showing the potential between the source and the drain of the FET, before pinch-off and after pinch-off, where the "POTENTIAL" in the figures represents potential energy;

FIG. 18A is a cross sectional view schematically showing an area around a channel region and a gate region of a SIT (static induction transistor), and FIG. 18B is a graph showing the potential between the source and the drain of the SIT, before pinch-off and after pinch-off, where the "POTENTIAL" in the figures represents potential energy;
FIG. 19 is a cross sectional view showing main components of a semiconductor device (sixth semiconductor device) according to a sixth embodiment of the present invention; and
FIG. 20 is a cross sectional view showing main components of a semiconductor device (seventh semiconductor device) according to a seventh embodiment of the present invention.

Description of Embodiments

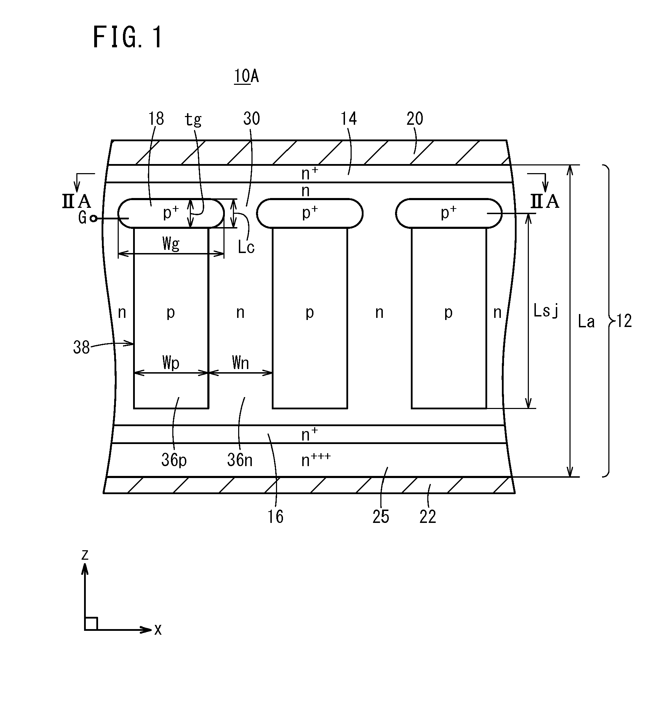

Hereinafter, an embodiment of a semiconductor device according to the present invention will be described with reference to FIGS. 1 to 20. It should be noted that, in this description, a numeric range of "A to B" includes both the numeric values A and B as lower and upper limit values.

Firstly, as shown in FIG. 1, a semiconductor device according to a first embodiment of the present invention (hereinafter referred to as a first semiconductor device 10A) includes an n-type semiconductor region 12 (this region may comprise a semiconductor substrate), an n-type source region 14 having high impurity concentration formed on one surface of the semiconductor region 12, an n-type drain region 16 formed on another surface of the semiconductor region 12, and a plurality of p-type embedded gate regions 18 which are located closer to the source region 14 than to the drain region 16 in the semiconductor region 12. In FIG. 1, it should be noted that the plurality of embedded gate regions 18 are electrically connected to a gate electrode (denoted by a symbol "G").

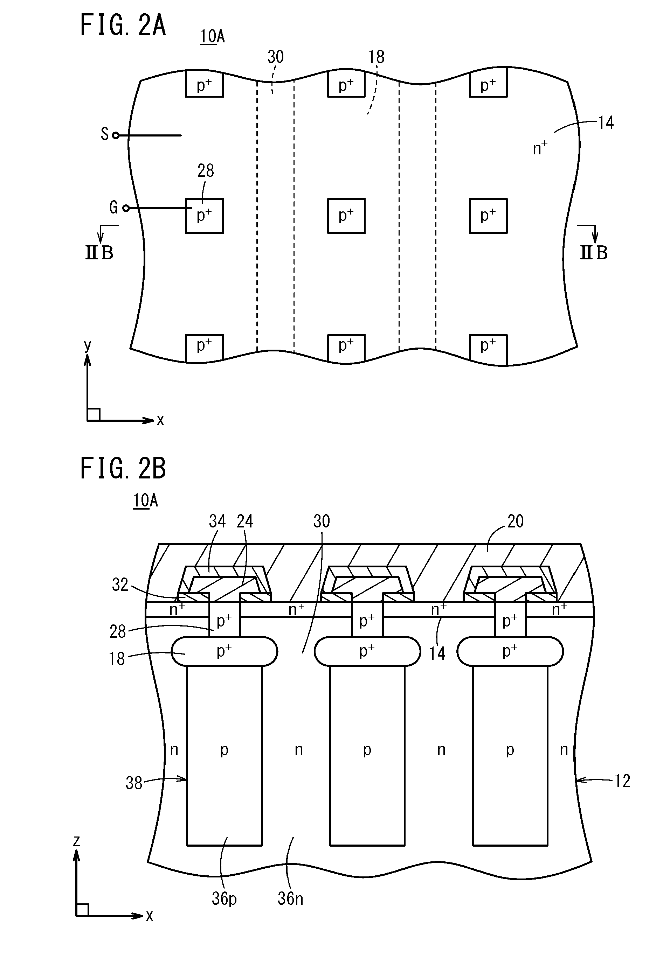

Further, this first semiconductor device 10A includes a source electrode 20 formed at a position corresponding to the source region 14, a drain electrode 22 formed at a position corresponding to the drain region 16, and a plurality of gate electrodes 24 insulated electrically from the source electrode 20 and controlling current flowing between the source electrode 20 and the drain electrode 22 (see FIG. 2B). Though not shown, the gate electrodes 24 are electrically connected together, e.g., at the periphery of the source region 14. An n-type high concentration region 25 is formed between the drain region 16 and the drain electrode 22.

As shown in FIG. 2B, a plurality of p-type gate extraction regions 28 electrically connecting the respective gate electrodes 24 and the embedded gate regions 18 are formed at positions between the gate electrodes 24 and the embedded gate regions 18. Portions of the semiconductor region 12 between the adjacent embedded gate regions 18 form channel regions 30.

As shown in FIG. 2A, the embedded gate regions 18 extend in a first direction indicated by an arrow y, and the embedded gate regions 18 are arrayed in a second direction in a direction indicated by an arrow x, perpendicular to the first direction. As shown in FIG. 1, the width Wg of the embedded gate regions 18 is larger than the width Wp of first regions 36p (forming super junction structure 38 described later) such that the adjacent embedded gate regions 18 protrude toward each other. That is, the embedded gate regions 18 are connected to upper portions of the first regions 36p. FIG. 1 shows an example where the cross sectional shape of the embedded gate regions 18 has a flat-oval track shape. FIG. 2A shows a cross section taken along a line IIA-IIA in FIG. 1, and FIG. 2B shows a cross section taken along a line IIB-IIB in FIG. 2A. Further, in FIG. 2A, the embedded gate regions 18 are electrically connected to the gate electrode (denoted by the symbol "G") through gate extraction regions 28, and the source region 14 is electrically connected to the source electrode (denoted by the symbol "S").

As shown in FIG. 2A, as in the case of the embedded gate regions 18 described above, the channel regions 30 extend in the first direction indicated by the arrow y, and the channel regions 30 are arrayed in the second direction indicated by the arrow x, perpendicular to the first direction. As shown in FIG. 1, it is preferable that the length Lc of the channel regions 30 (length in a third direction indicated by an arrow z (referred to as the channel length Lc)) is short. In this regard, the width Wg of the embedded gate region 18 is larger than the width Wp of the first region 36p and both sides of the embedded gate region 18 protrude transversely beyond the first region 36p. In the structure, in effect, the channel length Lc is limited to the thickness tg of the embedded gate region 18. The channel length Lc is equal to or shorter than the thickness tg of the embedded gate region 18. Specifically, the ratio of the channel length Lc to the thickness La of the semiconductor region 12, i.e., Lc/La is 8/100 or less (Lc/La ≤ 8/100), and preferably in a range of 1/300 to 6/100 (1/300 s Lc/La ≤ 6/100).

As shown in FIGS. 1, 2A, and 2B, the source region 14 is a single region extending over one surface of the semiconductor region 12 excluding the gate extraction regions 28 extending through the source region 14. That is, the source region 14 extends over the adjacent channel region 30.

As shown in FIG. 2B, a first insulating film 32 made of material such as $SiO_2$, etc. is interposed between the gate electrodes 24 and the source region 14. Further, the source electrode 20 is formed over the entire surface including the gate electrodes 24. A second insulating film 34 made of TEOS (Tetra EthOxy Silane: Si$(OC_2H_5)_4$) is interposed between each of the gate electrodes 24 and the source electrode 20.

Further, as shown in FIGS. 1 and 2B, the first semiconductor device 10A has the super junction structure 38. The super junction structure 38 includes a plurality of p-type first regions 36p extending from the embedded gate regions 18 toward the drain region 16, and an n-type second region 36n between the first regions 36p. In this regard, preferable impurity concentration of the source region 14, the drain region 16, the embedded gate region 18, and the first region 36p (second region 36n) are as follows: Specifically, preferable impurity concentration of the source region 14 is $10^{17}$ cm$^{-3}$ or more and less than $10^{21}$ cm$^{-3}$, preferable impurity concentration of the drain region 16 is $10^{17}$ cm$^{-3}$ or more and less than $10^{21}$ cm$^{-3}$, preferable impurity concentration of the embedded gate region 18 is $10^{16}$ cm$^{-3}$ or more and less than $10^{18}$ cm$^{-3}$, and preferable impurity concentration of the first region 36p (second region 36n) is $10^{15}$ cm$^{-3}$ or more and less than $10^{18}$ cm$^{-3}$.

The total impurity amount of the first regions 36p of the super junction structure 38 is substantially the same as the total impurity amount of the second regions 36n of the super junction structure 38. In the case where the width Wp of the first regions 36p of the super junction structure 38 and the width Wn of the second regions 36n of the super junction structure 38 are the same, the impurity concentration of the first regions 36p of the super junction structure 38 and the impurity concentration of the second regions 36n of the super junction structure 38 are substantially the same. The expression "substantially the same" herein means a state where the following condition is satisfied.

$$|NA-ND|/ND \leq 5 \ (\%)$$

where NA is impurity concentration of the first regions 36p, and ND is impurity concentration of the second regions 36n. This point will be described later.

Further, as shown in FIG. 1, the width Wp of the first regions 36p and the width Wn of the second regions 36n are substantially the same. The expression "substantially the same" herein means a state where the following condition is satisfied.

$$|width \ Wp - width \ Wn| \leq 0.1 \ \mu m$$

In this manner, the total impurity amount in the first regions 36p and the total impurity amount in the second regions 36n become substantially the same.

Further, preferably, the aspect ratio of the super junction structure 38 is large. In this manner, the ON resistance relative to a certain breakdown voltage can be reduced. The aspect ratio of the super junction structure 38 herein is {length Lsj in a longitudinal direction indicated by an arrow z/(width Wp/2 of the first regions 36p + width Wn/2 of the second regions 36n)}. The length Lsj in the longitudinal direction is the length from the central position in the thickness direction of the embedded gate region 18 to the lower end of the super junction structure 38.

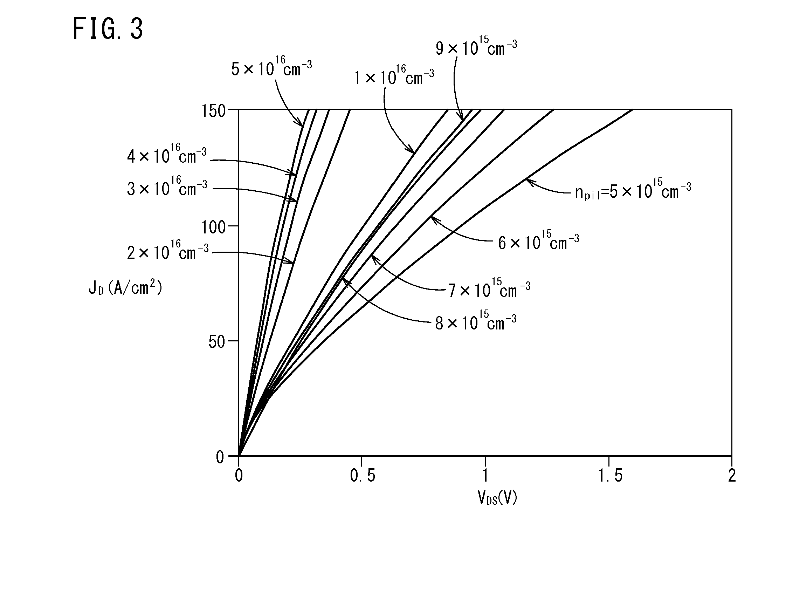

Next, ON state characteristics and OFF state characteristics of the first semiconductor device 10A will be described with reference to FIGS. 3 to 5.

Firstly, the following explanation is made on the premise that the aspect ratio of the super junction structure 38 is 16.5, the width Wp of the first regions 36p and the width Wn of the second regions 36n are 2 $\mu$m, respectively, and the ratio of the channel length Lc to the thickness La of the semiconductor region 12 is 1/300.

Based on this premise, changes of the ON characteristics and the OFF characteristics relative to the impurity concentration of the first regions 36p and the impurity concentration of the second regions 36n were checked. In this regard, the same impurity concentration was adopted for the first regions 36p and the second regions 36n. Therefore, simply, the impurity concentration of the first regions 36p and the impurity concentration of the second regions 36n will be simply referred to as the "impurity concentration $n_{pil}$".

The details of the impurity concentration $n_{pil}$ are shown in Table 1 below.

TABLE 1

| IMPURITY CONCENTRATION $n_{pil}$ (cm$^{-3}$) |
| --- |
| $5 \times 10^{15}$ |
| $6 \times 10^{15}$ |
| $7 \times 10^{15}$ |
| $8 \times 10^{15}$ |
| $9 \times 10^{15}$ |
| $1 \times 10^{16}$ |
| $2 \times 10^{16}$ |
| $3 \times 10^{16}$ |
| $4 \times 10^{16}$ |
| $5 \times 10^{16}$ |

With regard to each of impurity concentrations shown in Table 1, the gate-source voltage $V_{GS}$ is set to 0.7 V, and conduction current density $J_D$ (ON state characteristics) relative to the change in the drain-source voltage $V_{DS}$ was checked. The results are shown in FIG. 3.

As can be seen from FIG. 3, in this first semiconductor device 10A, the built-in potential of about 0.75 V generated in a normal SI thyristor is not present in the conduction path of the main current. It can be seen that, as in the case of MOSFET, the current rises from $V_{DS} = 0$ V when the device is turn on.

Further, as can be seen from the results of FIG. 3, as the increase in the impurity concentration $n_{pil}$, the rise of the conduction current density $J_D$ becomes steep. The change is substantially in correspondence with the concentration.

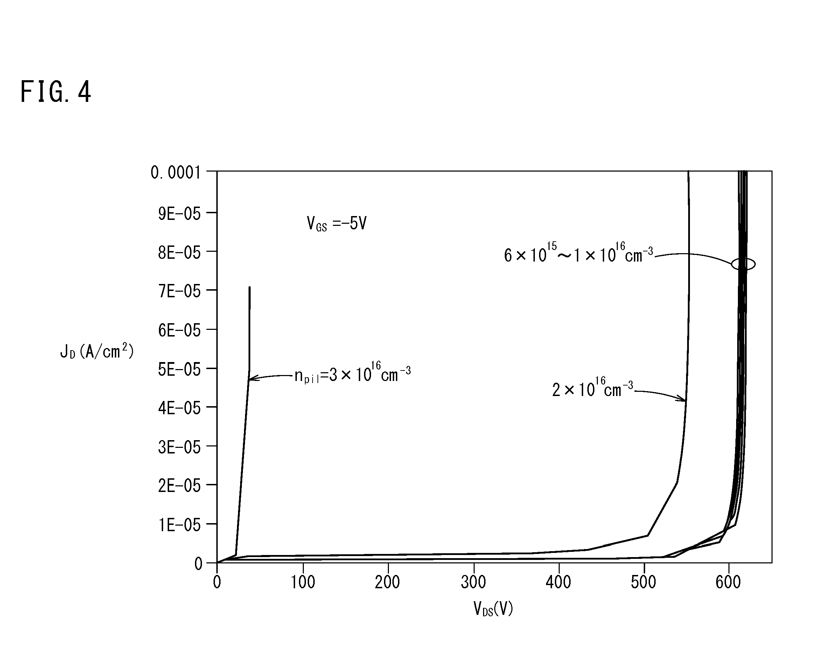

Further, with regard to each of impurity concentrations in Table 1, the gate-source voltage $V_{GS}$ is set to -5V (reverse bias), and the conduction current density $J_D$ (OFF state characteristics) relative to the change in the drain-source voltage $V_{DS}$ was checked. The results are shown in FIG. 4.

These OFF state characteristics do not change substantially when the impurity concentration $n_{pil}$ is in a range of $6 \times 10^{15}$ to $1 \times 10^{16}$ cm$^{-3}$, and the breakdown voltage is at a high voltage level. When the impurity concentration $n_{pil}$ is $2 \times 10^{16}$ cm$^{-3}$, the breakdown voltage decreases slightly, and when the impurity concentration $n_{pil}$ is $3 \times 10^{16}$ cm$^{-3}$, the breakdown voltage decreases sharply.

Therefore, based on the above premise, for improvement of both of the ON state characteristics and the OFF state characteristics, it is preferable that the impurity concentration is in a range of $6 \times 10^{15}$ cm$^{-3}$ or more and less than $3 \times 10^{16}$ cm$^{-3}$. This preferable range is merely an example. It is evident that the preferable range of the impurity concentration of the first regions 36p may vary depending on the required specification, etc. of the withstand voltage, for example.

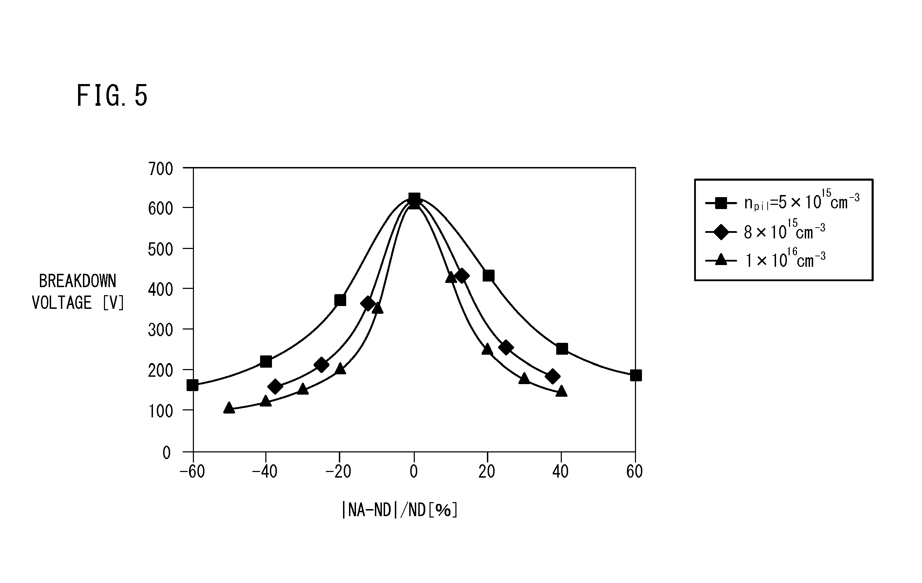

Next, the change in the breakdown voltage was checked in both of the case where the impurity concentration of the first regions 36p and the impurity concentration of the second regions 36n are the same and the case where the impurity concentration of the first regions 36p and the impurity concentration of the second regions 36n are different. As the premise, variation of the impurity concentration between the first regions 36p and the second regions 36n was determined by |NA-ND|/ND where NA is impurity concentration of the first regions 36p and ND is impurity concentration of the second region 36n. The change of the breakdown voltage relative to variation of this impurity concentration was plotted. The results are shown in FIG. 5.

As can be seen from FIG. 5, the breakdown voltage is decreased as the variation of the impurity concentration becomes large. In particular, if the impurity concentration $n_{Pil}$ is high, the breakdown voltage is decreased to a greater extent. In this case, if the decrease in the breakdown voltage is less than 50 V, it is possible to avoid the significant decrease of the OFF state characteristics. Therefore, it is preferable that variation |NA-ND|/ND of the impurity concentration between the first regions 36p and the second regions 36n falls within a range of 5% or less. That is, the expression "substantially the same" of "the impurity concentration of the first regions and the impurity concentration of the second regions are substantially the same" means that |NA-ND|/ND falls within a range of 5% or less.

As describe above, it is possible to achieve the good ON state characteristics and the good OFF state characteristics of the first semiconductor device 10A.

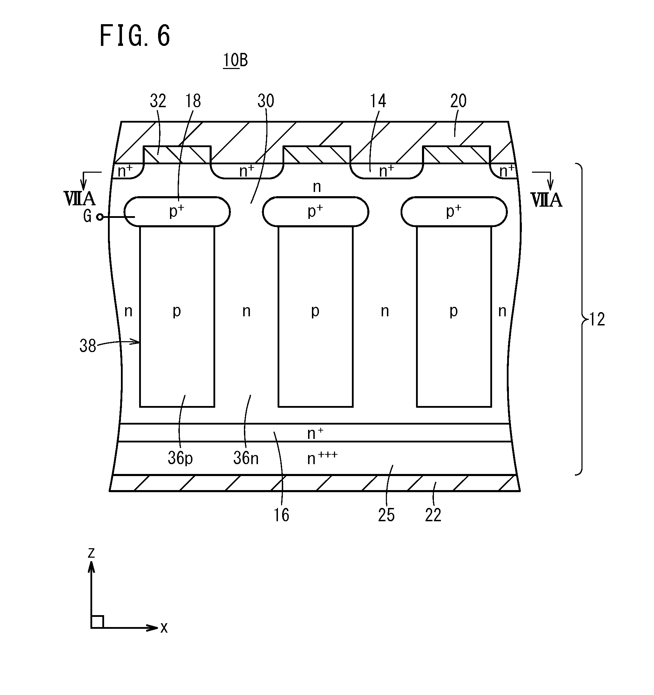

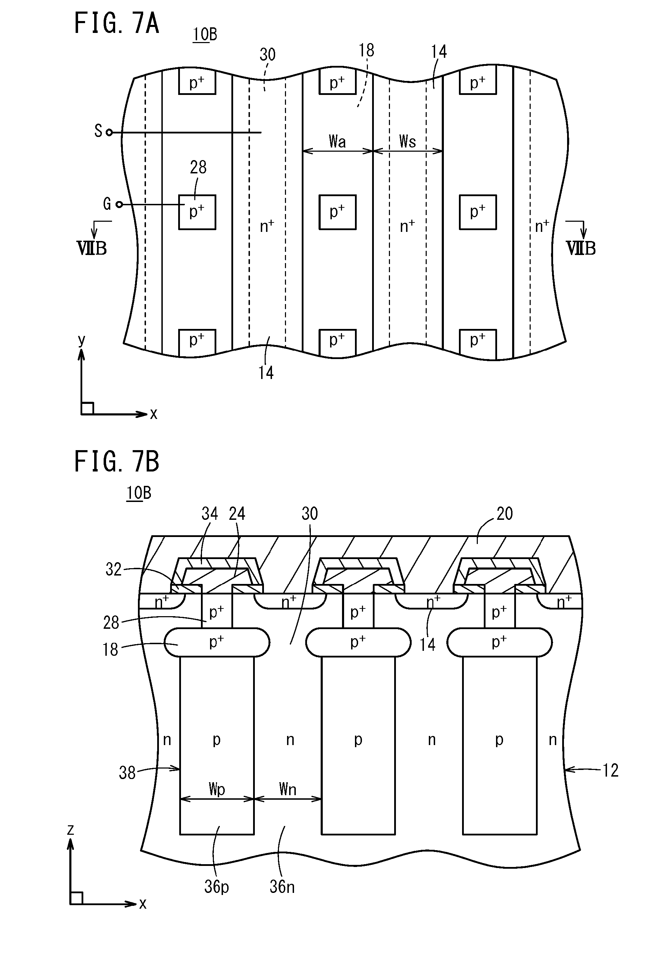

Next, a semiconductor device according to a second embodiment (hereinafter referred to as a second semiconductor device 10B) will be described with reference to FIGS. 6, 7A, and 7B.

This second semiconductor device 10B has substantially the same structure as the above described first semiconductor device 10A, and different from the above described first semiconductor device 10A in the following points. That is, in the second semiconductor device 10B, as shown in FIGS. 6, 7A, and 7B, the source region 14 is separated on the embedded gate regions 18, and each of the separate portions of the source regions 14 is formed in a stripe pattern extending on the channel region 30 in a first direction indicated by an arrow y. Stated otherwise, at least the source regions 14 and the junction surface of the super junction structure 38 (junction surface between the first region 36p and the second region 36n) extend in parallel to each other. The "parallel" herein may include variation in a range of 1° to 3°.

As the width Wa between the separate portions of the source region 14, a width which is substantially the same as the width Wp of the first region 36p, e.g., a width in a range between (width Wp - 0.1 μm) or more and (width Wp + 0.1 μm) or less may be adopted. As the width Ws of the source region 14, a width which is substantially the same as the width Wn of the second region 36n, e.g., a width in a range between (width Wn - 0.1 μm) or more and (width Wn + 0.1 μm) or less may be adopted.

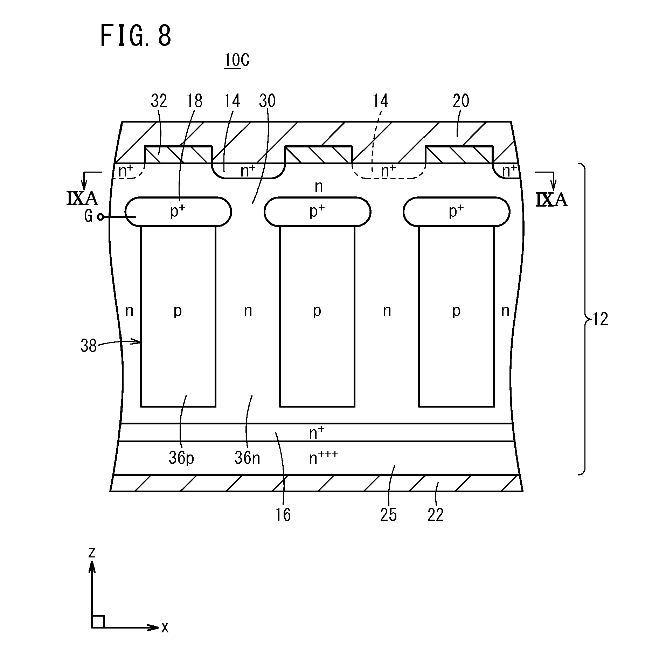

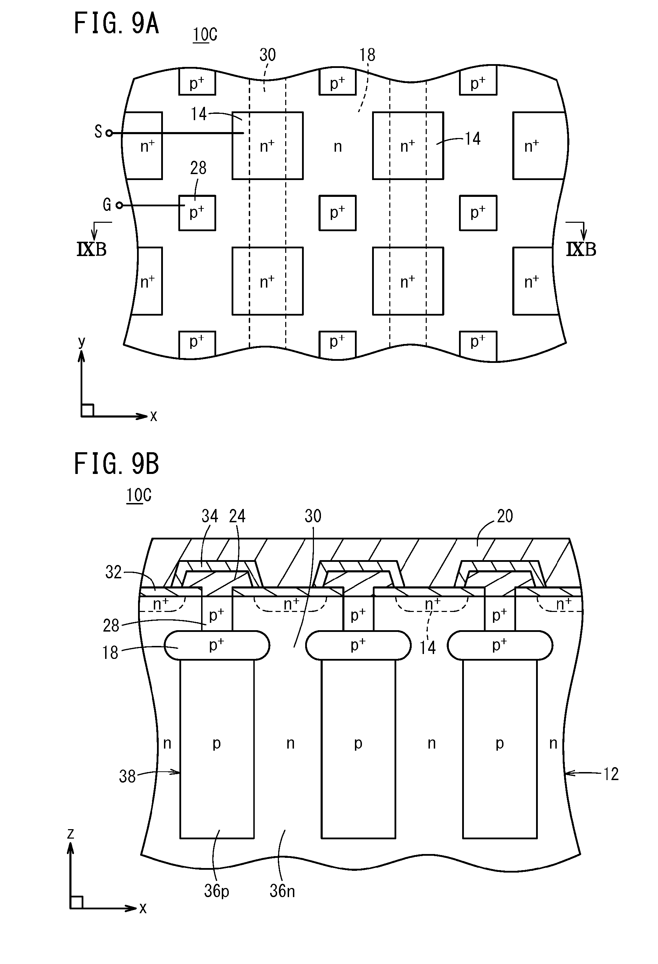

Next, a semiconductor device according to a third embodiment of the present invention (hereinafter referred to as a third semiconductor device 10C) will be described with reference to FIGS. 8, 9A, and 9B.

This third semiconductor device 10C have substantially the same structure as the above described second semiconductor device 10B, and different from the second semiconductor device 10B in that the source region 14 is separated into portions in an island pattern as shown in FIGS. 8, 9A, and 9B. In an example of FIG. 9A, a plurality of island portions of the source region 14 are arrayed in a matrix pattern in a first direction indicated by an arrow y and a second direction indicated by an arrow x. The island portions of the source region 14 may be arrayed in a matrix pattern, and may be arrayed in a zigzag or staggered pattern.

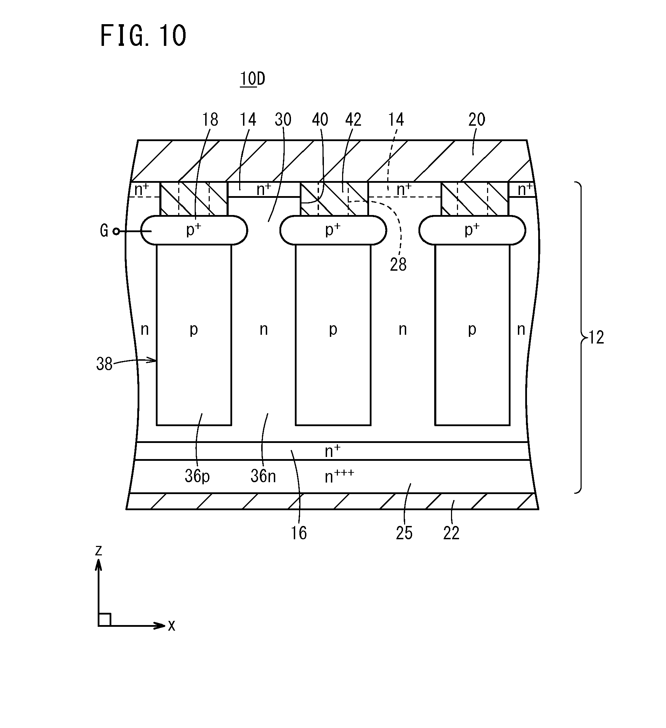

Next, a semiconductor device according to a fourth embodiment of the present invention (hereinafter referred to as a fourth semiconductor device 10D) will be described with reference to FIG. 10.

As shown in FIG. 10, the fourth semiconductor device 10D has trench grooves 40 on the embedded gate regions 18, in portions excluding the gate extraction regions 28 up to positions reaching the embedded gate regions 18. Insulating material 42 fills in the trench grooves 40. In this case, by suitably changing the planar shape of the trench grooves 40, the source region 14 can be formed in the stripe pattern or island pattern.

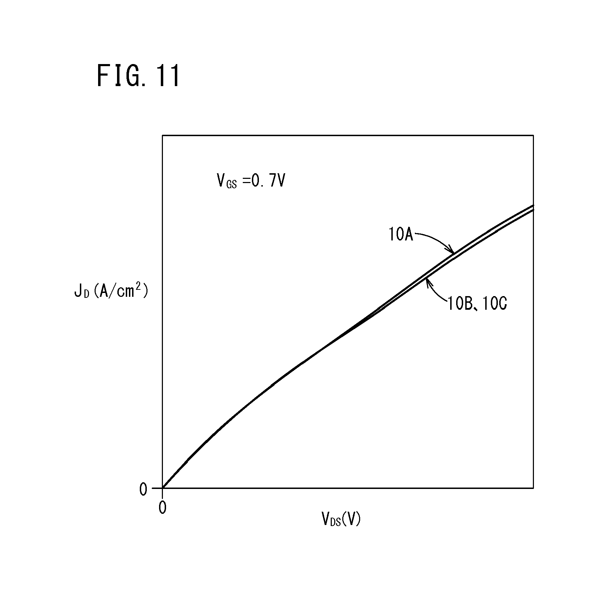

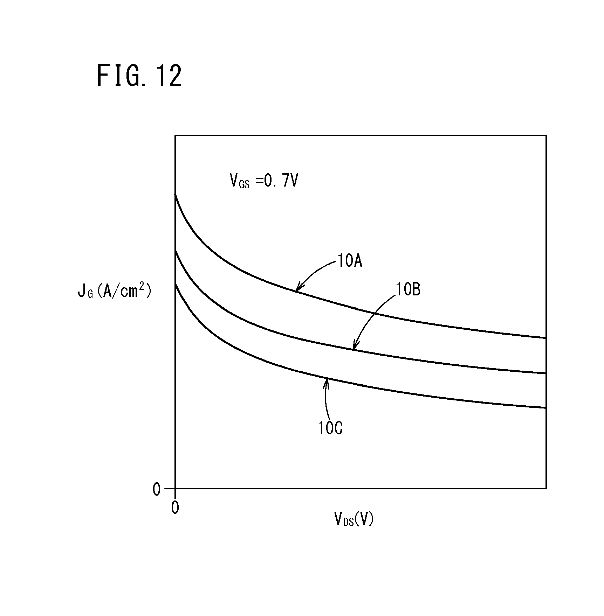

Next, differences between characteristics of the first semiconductor device 10A, the second semiconductor device 10B, and the third semiconductor device 10C, and in particular, the conduction current density $J_D$ and the gate current density $J_G$ depending on the change in the drain-source voltage $V_{DS}$ were checked. The results are shown in FIGS. 11 and 12. The gate-source voltage $V_{GS}$ is 0.7V.

Firstly, as shown in FIG. 11, all of the first semiconductor device 10A, the second semiconductor device 10B, and the third semiconductor device 10C have substantially the same characteristics in respect of the change in the conduction current density $J_D$ relative to the drain-source voltage $V_{DS}$. Further, as the drain-source voltage $V_{DS}$ increases, the conduction current density $J_D$ changes substantially linearly. Therefore, in effect, the first semiconductor device 10A, the second semiconductor device 10B, and the third semiconductor device 10C are regarded as resistors.

Then, as shown in FIG. 12, based on the change in the gate current density $J_G$ relative to the drain-source voltage $V_{DS}$, it has been proven that the amount of the gate current flowing through the first semiconductor device 10A is the largest and the amount of the gate current flowing through the second semiconductor device 10B is the second largest. The third semiconductor device 10C has the lowest current density $J_G$. This is because, the first semiconductor device 10A forms a single region where the source region 14 extends over the entire one surface of the semiconductor region 12. Therefore, the area of the embedded gate regions 18 and the source region 14 which face each other in the first semiconductor device 10A is wide in comparison with the cases of the second semiconductor device 10B and the third semiconductor device 10C. Additionally, the effective distance between the embedded gate regions 18 and the source region 14 is short. For this reason, it is considered that the resulting gate current density $J_G$ is high.

In contrast, in the second semiconductor device 10B, since the planar shape of the source region 14 is the stripe pattern, the area where the embedded gate regions 18 and the source region 14 face each other is narrow in comparison with the case of the first semiconductor device 10A. The effective distance between the embedded gate regions 18 and the source region 14 is large. For this reason, it is considered that the resulting gate current density $J_G$ is low in comparison with the case of the first semiconductor device 10A.

In the third semiconductor device 10C, the planar shape of the source region 14 has an island pattern, and the area where the embedded gate regions 18 and the source region 14 face each other is narrow in comparison with the case of the second semiconductor device 10B. For this reason, it is considered that the gate current density $J_G$ of the third semiconductor device 10C is low in comparison with the case of the second semiconductor device 10B.

Once the first semiconductor device 10A to the third semiconductor device 10C are turned on, the gate current continues to flow until supply of the gate current is stopped. As described above, the first semiconductor device 10A to the third semiconductor device 10C are considered as resistors. Therefore, the heat quantity (Joule heat) H generated by the gate current can be calculated by the following equation:

$$H = I_{GS}^2 \times R \times t$$

where $I_{GS}$ is the gate current, R is the sum of the parasitic resistance component between the gate electrode 24 and the source electrode 20 of the first semiconductor device 10A to the third semiconductor device 10C and the external resistances of the gate electrode 24, and t is time. That is, it can be seen that the generated heat quantity H is increased proportionally to the square of the gate current $I_{GS}$.

Therefore, in the case where the present invention is applied to a device (breaker, etc.) where ON operation of the semiconductor device continues for a long period of time, it is preferable to use the second semiconductor device 10B or the third semiconductor device 10C having lower gate current density, and more preferable to use the third semiconductor device 10C, rather than using the first semiconductor device 10A.

In the third semiconductor device 10C, at least the source region 14 and the junction surface of the super junction structure 38 extend in parallel to each other. Alternatively, the source region 14 and the junction surface of the super junction structure 38 may extend in particular to each other. The "perpendicular" herein may include variation in the range of 1° to 3°. In the case where the source region 14 and the junction surface of the super junction structure 38 extend in perpendicular to each other, since the channel region 30 includes a portion where no source region 14 is present, though the utilization efficiency of the channel is low in comparison with the case where the source region 14 and the junction surface of the super junction structure 38 extend in parallel to each other, this structure is advantageous for downsizing.

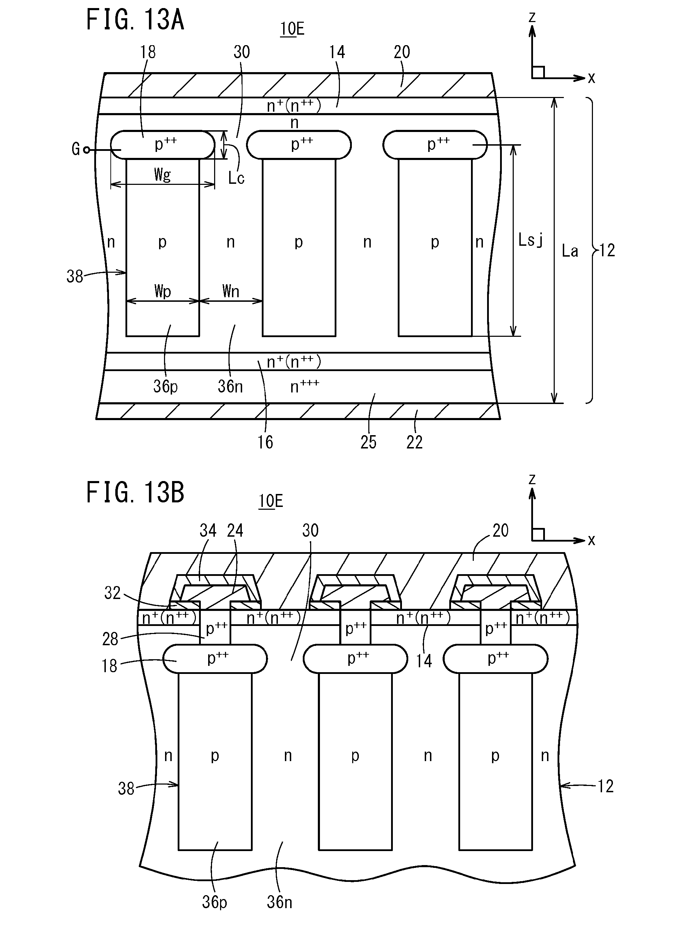

Next, a semiconductor device according to a fifth embodiment (hereinafter referred to as a fifth semiconductor device 10E) will be described with reference to FIGS. 13A and 13B.

As shown in FIGS. 13A and 13B, this fifth semiconductor device 10E has substantially the same structure as the above described first semiconductor device 10A, and different from the first semiconductor device 10A in that the impurity concentration of at least the embedded gate regions 18 is high. In this regard, the preferable range of the impurity concentration of the embedded gate regions 18 is a range between $10^{18}$ cm$^{-3}$ or more and less than $10^{21}$ cm$^{-3}$. Further, the impurity concentration of the source regions 14 is at the middle level or high level in the above described preferable range (between $10^{17}$ cm$^{-3}$ or more and $10^{21}$ cm$^{-3}$ or less). The impurity concentration of the drain region 16 is also at the middle level or high level in the above described preferable range (between $10^{17}$ cm$^{-3}$ or more and $10^{21}$ cm$^{-3}$ or less).

In FIGS. 13A and 13B, the semiconductor region 12 is labeled with "n", the source region 14 is labeled with "n+(n++)", the drain region 16 is labeled with "n$^+$(n$^{++}$)", the embedded gate region 18 is labeled with "p$^{++}$", the gate extraction region 28 is labeled with "p$^{++}$", and the first region 36p of the super junction structure 38 is labeled with "p".

Next, characteristic differences between the fifth semiconductor device 10E and the conventional structure will be described with reference to FIGS. 13A to 16B.

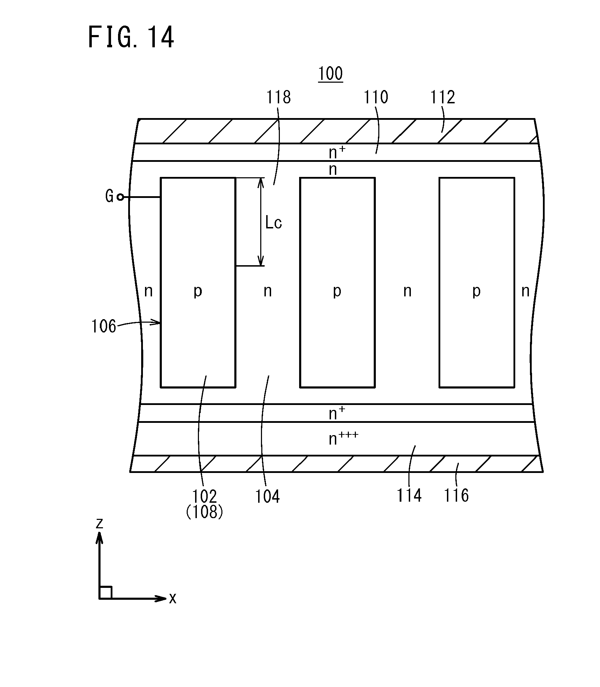

As shown in FIG. 14, in the semiconductor device 100 having the conventional structure, each of p-type gate drift layers 102 is expanded in a longitudinal direction to form a columnar shape, and super junction structure 106 is formed by the p-type gate drift layer 102 and an n-type drift layer 104. Further, in this semiconductor device 100, the p-type gate drift layer 102 also serves as a gate region 108 (see FIG. 3 of Japanese Laid-Open Patent Publication No. 2010-045218). An n-type source region 110 is formed on the surface of the n-type drift layer 104, and a source electrode 112 is formed to contact this source region 110. An n-type drain region 114 is formed on the back surface of the n-type drift layer 104, and a drain electrode 116 is formed to contact this drain region 114. In this semiconductor device 100, since the p-type gate drift layer 102 also serves as the gate region 108, the length of the channel region 118 (channel length Lc) is long.

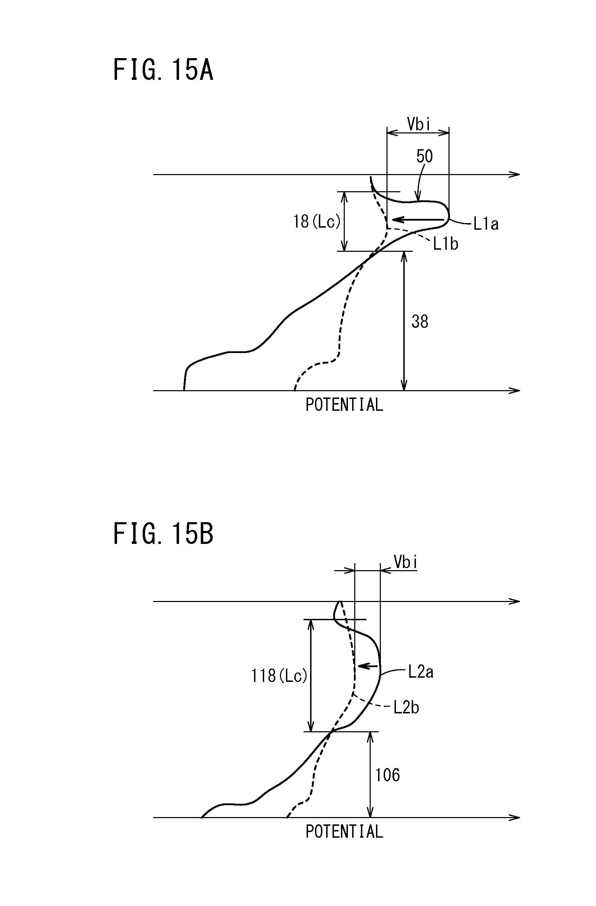

Further, when the fifth semiconductor device 10E is in the OFF state, as shown by a solid line L1a in FIG. 15A, a potential barrier 50 is formed at a portion corresponding to the channel region 30, due to a depletion layer. In particular, in the fifth semiconductor device 10E, since the channel length Lc is shorter than the semiconductor device 100, as shown by the solid line L1a in FIG. 15A, the potential barrier 50 is formed in a narrow range, and the height of the potential barrier 50 (built-in potential Vbi) becomes large. As a result, the withstand voltage in the OFF state becomes high. Further, since the super junction structure 38 can be formed to have a large size in the longitudinal direction, the effect of the super junction structure 38 can be exerted sufficiently.

When the fifth semiconductor device 10E is in the ON state, as shown by a broken line L1b in FIG. 15A, the potential barrier 50 is lowered, and a small degree of height is maintained. In the fifth semiconductor device 10E, since the channel length Lc is short, even in the case where the lowered potential barrier 50 protrudes to some extent, since the protrusion is present in a narrow range, it does not obstruct the flow of electric charges. That is, it is possible to reduce the ON resistance Ron.

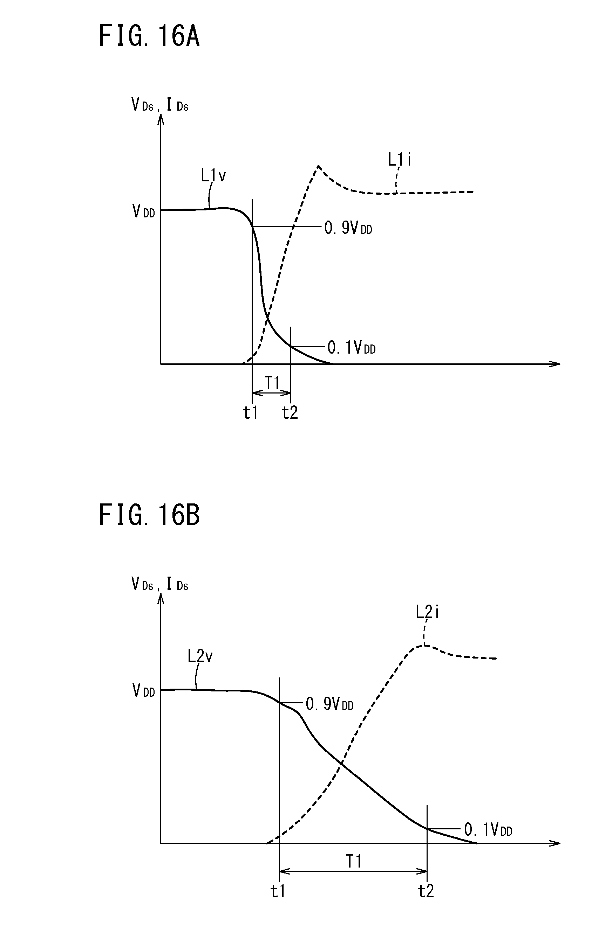

Further, as described above, in the OFF state, as shown by the solid line L1a in FIG. 15A, since the potential barrier 50 is formed in a narrow range, in the ON state, it becomes possible to rapidly lower the potential barrier 50. Therefore, as shown in FIG. 16A, it is possible to reduce the time (rise time T1) from a time point t1 when the drain-source voltage $V_{DS}$ reaches $0.9V_{DD}$ (when the gate is placed in the ON state) to a time point t2 when the drain-source voltage $V_{DS}$ reaches $0.1V_{DD}$.

It should be noted that FIG. 16A is a characteristic graph showing the change in the drain-source voltage $V_{DS}$ (see solid line L1v) and the output current $I_{DS}$ (see broken line L1i) over time at the time of turning on the fifth semiconductor device 10E.

Further, in the fifth semiconductor device 10E, it is possible to increase the current amplification factor hfe to about 400. Further, during ON operation, when a positive voltage is applied between the gate and the source, and minority carriers from the embedded gate regions 18 having low impedance are injected into the channel region 30 significantly, conductivity amplification is induced in the channel region 30. As a result, the resistance component of the channel part is reduced, and the ON resistance is reduced to a further greater extent. In the meanwhile, since minority carriers are not injected into super junction structure 38 significantly, the turn-off speed is not decreased.

As described above, in the fifth semiconductor device 10E, it is possible to realize the high withstand voltage in the OFF state, and reduce the ON resistance Ron in the ON state. Further, it is possible to increase the switching speed to a high speed, and reduce losses caused by switching.

In contrast, in the case of the semiconductor device 100 having conventional structure, in the OFF state, as shown by a solid line L2a in FIG. 15B, a potential barrier 50 is formed in a wide range. Therefore, in the ON state, it takes considerable time to lower the potential barrier 50. For this reason, as shown in FIG. 16B, the time (rise time T1) from a time point t1 when the drain-source voltage $V_{DS}$ reaches $0.9V_{DD}$ (when the gate is placed in the ON state) to a time point t2 when the drain-source voltage $V_{DS}$ reaches $0.1V_{DD}$ is three to five times as long as that of the fifth semiconductor device 10E. It should be noted that FIG. 16B is a characteristic graph showing the change in the drain-source voltage $V_{DS}$ (see solid line L2v) and the output current $I_{DS}$ (see broken line L2i) over time at the time of turning on the semiconductor device 100 having conventional structure.

As described above, in the semiconductor device 100 having the conventional structure, the ON resistance in the ON state may become high disadvantageously. Further, it may not be possible to increase the switching speed to a high speed, and losses caused by switching are increased disadvantageously.

The difference in respect of effects between the above described fifth semiconductor device 10E and the semiconductor device 100 having the conventional structure can be ascertained from the difference between the FET (field effect transistor) and the SIT (static induction transistor) (Japanese Patent No. 0205068 (Japanese Patent Publication No. 28-006077).

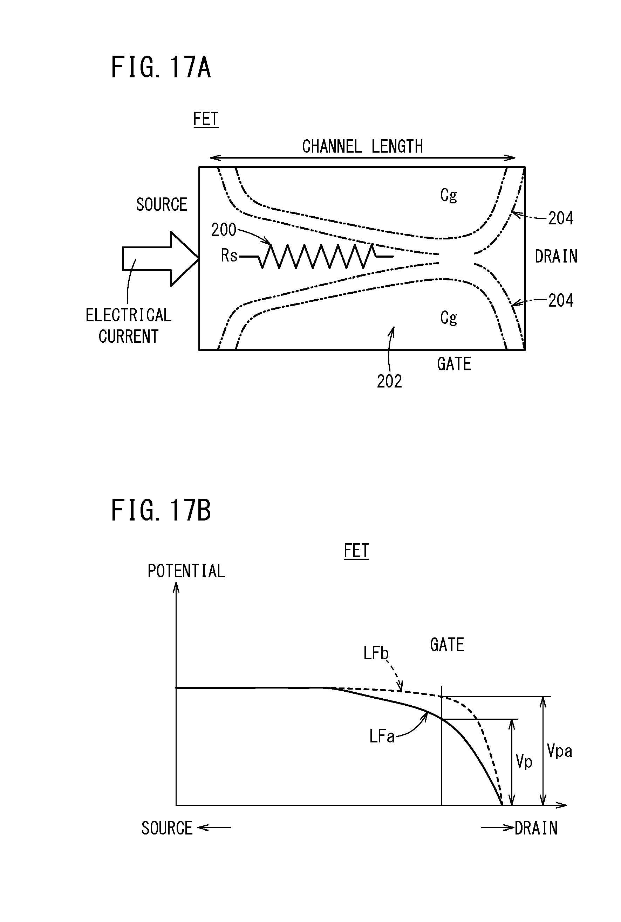

Specifically, next, a case of applying reverse bias between a channel region 200 and a gate region 202 in the FET and the SIT will be considered with reference to FIGS. 17A to 18B.

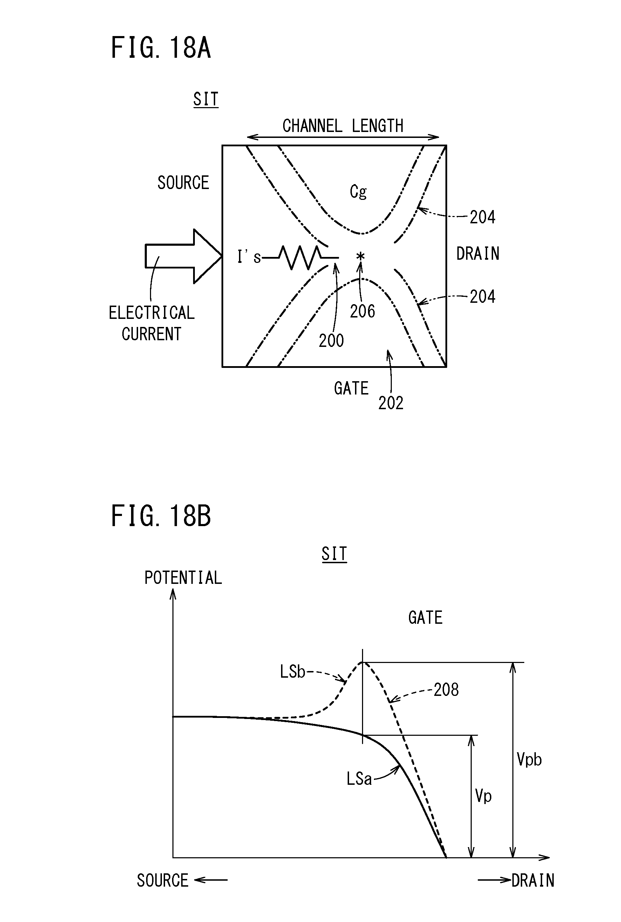

FIGS. 17A and 18A are cross sectional views schematically showing an area around the channel region 200 and the gate region 202 of the FET and, and an area around the channel region 200 and the gate region 202 of the SIT, respectively. FIGS. 17B and 18B are views showing the potential between the source and the drain of the FET and the potential between the source and the drain of the SIT before pinch-off and after pinch-off, respectively.

In FIGS. 17A and 18A, borders of a depletion layer 204 before pinch-off are shown by one-dot chain lines, and borders of the depletion layer 204 after pinch-off are shown by two-dot chain lines. Further, in FIG. 17B, a curve LFa and a curve LFb show potentials before pinch-off and after pinch-off in the FET, and in FIG. 18B, a curve LSa and a curve LSb show potentials before pinch-off and after pinch-off in the SIT.

In the FET, as shown in FIG. 17A, a reverse bias is applied between the channel region 200 and the gate region 202, and the level Vpa of the potential at the time of contact with the depletion layer 204 which is expanded from the gate region 202 toward the channel region 200, i.e., at the time of pinch-off, is not increased significantly from the level Vp of the potential before pinch-off. In comparison with the case of the SIT (see FIG. 18B), the potential level is low. Therefore, by increasing the channel length to increase the electrical resistance Rs of the channel region 200, the flow of electrons is restricted. However, the above electrical resistance Rs is operated as ON resistance at the time of turning on the FET, and consequently, electrostatic induction effect cannot be exerted sufficiently.

In contrast, in the SIT, as shown in FIG. 18B, the level Vpb of the potential after pinch-off is larger than the level Vp before pinch-off. Thus, a potential barrier 208 having a peak in its portion corresponding to a true gate 206 (see FIG. 18A) is formed. Therefore, in comparison with the case of the FET, the electrical resistance rs of the channel region 200 can be reduced, the channel length can be shortened, and the ON resistance can be reduced. Consequently, electrostatic induction effect can be exerted sufficiently.

Comparison of the FET and the SIT has been described above. In particular, in the fifth semiconductor device 10E, the impurity concentration of at least the channel region 30 and the impurity concentration of the embedded gate regions 18 are increased. Therefore, electrical resistance of the channel region 30 is further reduced, and reduction of the ON resistance is further facilitated. Further, the impurity concentration of the channel region 30 is increased, and additionally, the impurity concentration of the embedded gate regions 18 is increased. Accordingly, it is possible to decreases a gate resistance, and decrease a gate impedance. As a result, as in the case of this embodiment, even if the channel region 30 is formed continuously over a wide range, or scattered over a wide range, uniform operation can be achieved (gate low impedance effect). Further, since the ON resistance is low at the time of conduction, it is possible to perform ON/OFF operation at high speed advantageously.

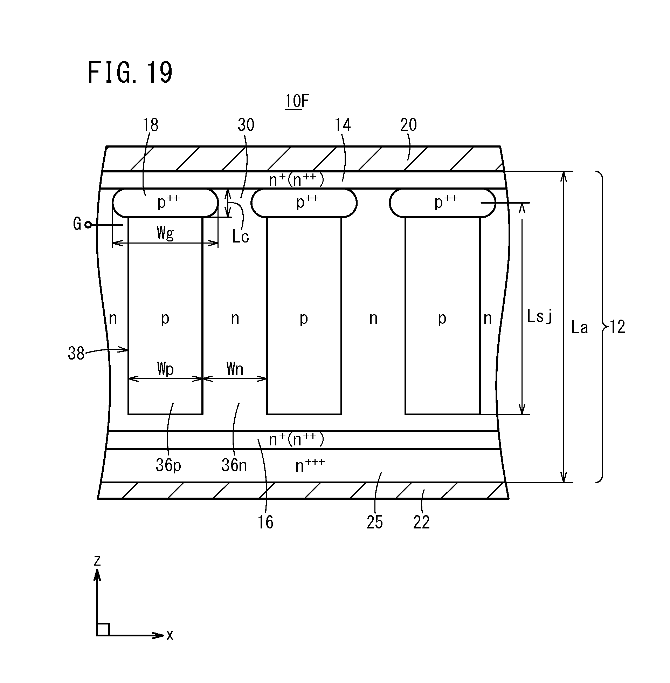

Next, a semiconductor device according to a sixth embodiment (hereinafter referred to as a sixth semiconductor device 10F) will be described with reference to FIG. 19.

As shown in FIG. 19, this sixth semiconductor device 10F has substantially the same structure as the above described fifth semiconductor device 10E, and different from the fifth semiconductor device 10E in that the distance between the upper ends of the embedded gate regions 18 and the lower end of the source region 14 is extremely close to 0mm. FIG. 19 shows a state where the upper ends of embedded gate regions 18 contact the lower end of the source region 14.

In this case, as the distance between the upper ends of the embedded gate regions 18 and the lower end of the source region 14 get extremely closer to 0mm, reduction of the ON resistance can be achieved to a greater extent. Further, in this sixth semiconductor device 10F, since the embedded gate regions 18 having high concentration are present, as in the case of the fifth semiconductor device 10E, it is possible to realize the high withstand voltage in the OFF state, and improve the responsiveness.

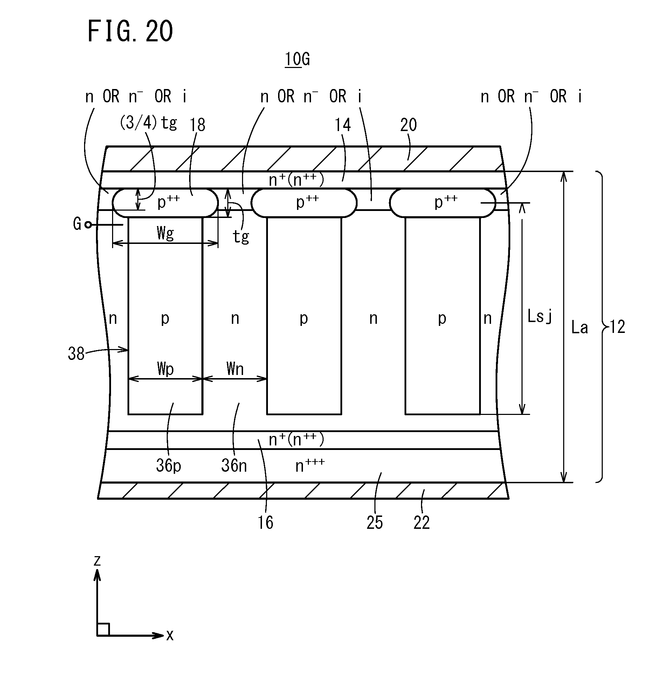

Next, a semiconductor device according to a seventh embodiment (hereinafter referred to as a seventh semiconductor device 10G) will be described. As shown in FIG. 20, the seventh semiconductor device 10G have substantially the same structure as the sixth semiconductor device 10F, and different from the sixth semiconductor device 10F in that an n-type region having low concentration or an intrinsic semiconductor region 52 is located over the depth which is larger than the 1/2 and equal to or less than 5/6 of the thickness tg of the embedded gate regions 18, from the upper ends of the embedded gate regions 18. In an example of FIG. 20, the n-type region having low concentration or intrinsic semiconductor region 52 is located over the depth which is the 3/4 of the thickness tg of the embedded gate regions 18, from the upper ends of the embedded gate regions 18. Based on the relationship with the impurity concentration of the embedded gate regions 18 and the source region 14, it is preferable that the impurity concentration of the n-type region having low concentration or intrinsic semiconductor region 52 is $10^{16}$ cm$^{-3}$ or less. Further, the n-type region having low concentration or intrinsic semiconductor region 52 may be an active high resistance semiconductor layer.

In this seventh semiconductor device 10G, since the n-type region having low concentration or intrinsic semiconductor region 52 is formed under the source region 14, and shallower than the thickness tg of the embedded gate regions 18, the depletion layer tends to be expanded in the OFF state, and it becomes possible to further improve the withstand voltage. Moreover, it is possible to lower the ON resistance. Consequently, switching can be performed at high speed, and switching losses are reduced.

It is a matter of course that the semiconductor device according to the present invention is not limited to the embodiments described above, and various structures can be adopted without deviating the gist of the present invention.

**Claims**

1. A semiconductor device comprising:

   a semiconductor region (12) having a first conductivity type;
   a source region (14) having the first conductivity type formed on one surface of the semiconductor region (12);
   a drain region (16) having the first conductivity type formed on another surface of the semiconductor region (12); and
   a plurality of embedded gate regions (18) having a second conductivity type which are located closer to the source region (14) than to the drain region (16) in the semiconductor region (12),
   wherein super junction structure (38) is formed by a plurality of first regions (36p) having the second conductivity type extending respectively from the embedded gate regions (18) toward the drain region (16) and a second region (36n) having the first conductivity type provided between the first regions (36p);
   the first regions (36p) are p-type, the second region (36n) is n-type, and the embedded gate regions (18) are p-type; and
   the embedded gate regions (18) are connected to upper portions of the first regions (36p).

2. The semiconductor device according to claim 1, wherein a width (Wg) of the embedded gate regions (18) is larger than a width (Wp) of the first regions (36p), both sides of the embedded gate regions (18) protrude in a transverse direction beyond the first regions (36p), a length (Lc) of the channel region (30) provided between the adjacent embedded gate regions (18) is equal to or less than a thickness (tg) of the embedded gate regions (18), an impurity concentration of the source region (14) is $10^{17}$ cm$^{-3}$ or more and less than $10^{21}$ cm$^{-3}$, an impurity concentration of the embedded gate regions (18) is $10^{18}$ cm$^{-3}$ or more and less than $10^{21}$ cm$^{-3}$, and an impurity concentration of the first regions (36p) is $10^{15}$ cm$^{-3}$ or more and less than $10^{18}$ cm$^{-3}$.

3. The semiconductor device according to claim 2, wherein upper ends of the embedded gate regions (18) contact a lower end of the source region (14).

4. The semiconductor device according to claim 3, further comprising an n-type region having low impurity concentration of $10^{16}$ cm$^{-3}$ or less, or an intrinsic semiconductor region (52), or an active high resistance semiconductor layer that is located over a depth which is larger than 1/2 and equal to or less than 5/6 of the thickness (tg) of the embedded gate regions (18), from the upper ends of the embedded gate regions (18).

5. The semiconductor device according to any one of claims 1 to 4, wherein the embedded gate regions (18) extend in one direction, and are arrayed in another direction perpendicular to the one direction.

6. The semiconductor device according to claim 5, wherein portions of the semiconductor region (12) between the embedded gate regions (18) form channel regions (30); and
   the channel regions (30) extend in the one direction, and are arrayed in the other direction.

7. The semiconductor device according to claim 6, wherein the source region (14) extends over the channel regions (30).

8. The semiconductor device according to claim 6, wherein at least the source region (14) and a junction surface of the super junction structure (38) extend in parallel to each other.

9. The semiconductor device according to claim 6, wherein at least the source region (14) and a junction surface of the super junction structure (38) extend in perpendicular to each other.

10. The semiconductor device according to claim 6, wherein the source region (14) is separated into separate portions; and
    on the channel regions (30), the separate portions of the source region (14) extend in the one direction, and are arrayed in the other direction.

11. The semiconductor device according to claim 10, wherein the source region (14) is separated into island portions; and
    the island portions of the source region (14) are arrayed in the one direction and the other direction.

12. The semiconductor device according to any one of claims 6 to 11, wherein a ratio of a length (Lc) of the channel region (30) to a thickness (La) of the semiconductor region (12) is equal to or less than 8/100.

13. The semiconductor device according to claim 12, wherein the length (Lc) of the channel region (30) to the thickness (La) of the semiconductor region (12) is 1/300 or more and 6/100 or less.

**14.** The semiconductor device according to any one of claims 1 to 13, wherein a width (Wp) of the first region (36p) is substantially the same as a width (Wn) of the second region (36n).

**15.** The semiconductor device according to any one of claims 1 to 14, wherein a total impurity amount of the first regions (36p) is substantially same as a total impurity amount of the second regions (36n).

# FIG. 1

# FIG. 2A

# FIG. 2B

FIG. 3

$J_D$ (A/cm$^2$)

$n_{pil}=5 \times 10^{15}$ cm$^{-3}$

$6 \times 10^{15}$ cm$^{-3}$

$7 \times 10^{15}$ cm$^{-3}$

$8 \times 10^{15}$ cm$^{-3}$

$9 \times 10^{15}$ cm$^{-3}$

$1 \times 10^{16}$ cm$^{-3}$

$5 \times 10^{16}$ cm$^{-3}$

$4 \times 10^{16}$ cm$^{-3}$

$3 \times 10^{16}$ cm$^{-3}$

$2 \times 10^{16}$ cm$^{-3}$

$V_{DS}$(V)

FIG. 4

EP 2 963 678 A1

$V_{GS} = -5V$

$6 \times 10^{15} \sim 1 \times 10^{16} cm^{-3}$

$J_D (A/cm^2)$

$n_{pil} = 3 \times 10^{16} cm^{-3}$

$2 \times 10^{16} cm^{-3}$

$V_{DS}(V)$

EP 2 963 678 A1

FIG. 5

FIG. 6

FIG. 7A

10B

S

G

28

VIIB

30        18        14

Wa        Ws

p⁺        p⁺        p⁺

p⁺        n⁺        p⁺        n⁺        p⁺        n⁺

p⁺        p⁺        p⁺

VIIB

y

x

14

FIG. 7B

10B

34   24        30              20

32

n⁺   p⁺        n⁺        p⁺        n⁺   p⁺        n⁺

28

18   p⁺                    p⁺                    p⁺

n        p        n        p        n        p        n

38        14

12

Wp        Wn

z

x

36p      36n

FIG. 8

FIG. 9A

10C

FIG. 9B

10C

FIG. 10

FIG. 11

## FIG. 12

$V_{GS} = 0.7V$

$J_G (A/cm^2)$

10A

10B

10C

0

0

$V_{DS}(V)$

FIG. 13A

FIG. 13B

# FIG. 14

FIG. 15A

FIG. 15B

FIG. 16A

FIG. 16B

## FIG. 17A

FET

CHANNEL LENGTH

SOURCE

Cg

204

200

Rs

DRAIN

204

ELECTRICAL
CURRENT

Cg

GATE

202

## FIG. 17B

FET

POTENTIAL

GATE

LFb

LFa

Vp

Vpa

SOURCE ←

→DRAIN

# FIG. 18A

SIT

# FIG. 18B

SIT

FIG. 19

# FIG. 20

# EP 2 963 678 A1

## INTERNATIONAL SEARCH REPORT

International application No.

PCT/JP2014/084600

### A. CLASSIFICATION OF SUBJECT MATTER

*H01L21/337*(2006.01)i, *H01L21/338*(2006.01)i, *H01L29/808*(2006.01)i, *H01L29/812*(2006.01)i

According to International Patent Classification (IPC) or to both national classification and IPC

### B. FIELDS SEARCHED

Minimum documentation searched (classification system followed by classification symbols)
H01L21/337, H01L21/338, H01L29/808, H01L29/812

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2015 |
| Kokai Jitsuyo Shinan Koho | 1971-2015 | Toroku Jitsuyo Shinan Koho | 1994-2015 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2010-045218 A (Toshiba Discrete Technology Corp.),<br>25 February 2010 (25.02.2010),<br>paragraphs [0014] to [0021]; fig. 3, 4<br>(Family: none) | 1<br>5-8,10-15<br>2-4,9 |
| Y<br>A | WO 2011/108768 A1 (National Institute of Advanced Industrial Science and Technology, University of Yamanashi),<br>09 September 2011 (09.09.2011),<br>page 12, lines 9 to 17; fig. 1<br>& JP 5585646 B | 5-8,10-15<br>2-4,9 |
| Y<br>A | JP 2005-005385 A (Toshiba Corp.),<br>06 January 2005 (06.01.2005),<br>paragraphs [0027] to [0038]; fig. 1, 2<br>(Family: none) | 8,10-15<br>2-4,9 |

☒ Further documents are listed in the continuation of Box C.   ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>29 January 2015 (29.01.15) | Date of mailing of the international search report<br>10 February 2015 (10.02.15) |
|---|---|
| Name and mailing address of the ISA/<br>Japan Patent Office<br>3-4-3,Kasumigaseki,Chiyoda-ku,<br>Tokyo 100-8915,Japan | Authorized officer<br><br>Telephone No. |

Form PCT/ISA/210 (second sheet) (July 2009)

32

**INTERNATIONAL SEARCH REPORT**

| International application No. |
|---|
| PCT/JP2014/084600 |

C (Continuation).   DOCUMENTS CONSIDERED TO BE RELEVANT

| Category* | Citation of document, with indication, where appropriate, of the relevant passages | Relevant to claim No. |
|---|---|---|
| Y<br>A | JP 2001-196605 A  (Hitachi, Ltd.),<br>19 July 2001 (19.07.2001),<br>paragraph [0053]; fig. 8<br>(Family: none) | 8,10-15<br>2-4,9 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012004173 A
- JP 3284120 B
- JP 2010045218 A
- JP 4832723 B
- JP 0205068 A
- JP 28006077 B